# EUROPÄISCHE PATENTSCHRIFT

(11) **EP 0 545 388 B1**
(45) Veröffentlichungstag und Bekanntmachung des Hinweises auf die Patenterteilung: **12.03.1997**
(21) Anmeldenummer: 92120576.1
(22) Anmeldetag: 02.12.1992
(51) Int. Cl.: H01L 33/00

(54) **Einrichtung mit einen lumineszenzfähigen Material und Verfahren zu ihrer Herstellung**
Device with a luminescent material and process of its fabrication
Dispositif comportant un matériau luminescent et procédé de fabrication

(30) Priorität: 03.12.1991 DE 4139852
(43) Veröffentlichungstag der Anmeldung: 09.06.1993
(73) Patentinhaber: Max-Planck-Gesellschaft zur Förderung der Wissenschaften e.V., D-37073 Göttingen (DE)
(72) Erfinder: Stutzmann, Martin, Dr., W-7000 Stuttgart 80 (DE); Brandt, Martin Stefan, W-7250 Leonberg (DE); Breitschwerdt, Alf, W-7000 Stuttgart 1 (DE); Fuchs, Heinz Daniel, W-7030 Böblingen (DE); Weber, Jörg, Dr., W-7016 Gerlingen (DE)
(74) Vertreter: von Bezold, Dieter, Dr.

(56) Entgegenhaltungen:
- JOURNAL OF NON-CRYSTALLINE SOLIDS Bd. 59/60, Dezember 1983, AMSTERDAM NL Seiten 645 - 648 HIRABAYASHI ET AL. 'OPTICAL PROPERTIES OF DISORDERED SILICIDE LAYER COMPOUND : SILOXENE(Si6(OH)3H3) - TIME RESOLVED LUMINESCENCE'
- JOURNAL OF VACUUM SCIENCE AND TECHNOLOGY: PART A. Bd. 6, Nr. 3, Mai 1988, NEW YORK US Seiten 1340 - 1342 MORAR ET AL. 'GROWTH OF EPITAXIAL CaSi2 FILMS ON Si(111)'
- APPLIED PHYSICS A. SOLIDS AND SURFACES Bd. 54, Nr. 6, Juni 1992, HEIDELBERG DE
- Seiten 567 - 569 BRANDT ET AL. 'NEW GROWTH TECHNIQUE FOR LUMINESCENT LAYERS ON SILICON'

## Beschreibung

Die vorliegende Erfindung betrifft eine Einrichtung, die ein lumineszenzfähiges Material enthält. Ferner betrifft die Erfindung Verfahren zum Herstellen von solchen Einrichtungen.

Viele Einrichtungen, wie Bildwandler, Displays, optoelektronische Schaltungen, optische IC's, Laser u.a.m. enthalten ein lumineszierendes Material, im allgemeinen entweder einen Kristallphosphor, wie ZnS:Mn, oder im Falle von elektrooptischen Einrichtungen auch einen pn-Übergang, typischerweise in einem III-V-Halbleitermaterial. Nachteilig an beiden Typen ist, daß sie mit der bewährten und in größtem Umfange angewandten Silizium-Technologie schlecht verträglich sind und daß zur Herstellung oft sehr schädliche Substanzen verwendet werden müssen. Es besteht außerdem Bedarf an neuen Lumineszenzmaterialien, insbesondere solchen die elektrisch anregbar sind.

In der Veröffentlichung von Hirabayashi (JOURNAL OF NON-CRYSTALLINE SOLIDS Bd. 59/60, Dezember 1983, AMSTERDAM, NL Seiten 645-648) wird die zeitaufgelöste Lumineszenz von optisch angeregtem Siloxen untersucht, wobei die Anregung durch kurze Impulse eines Farbstofflasers erfolgt.

Der vorliegenden Erfindung liegt dementsprechend in erster Linie die Aufgabe zugrunde, neuartige Einrichtungen, die ein lumineszenzfähiges Material enthalten, sowie Verfahren zur Herstellung von solchen Einrichtungen anzugeben, welche mit der Silizium-Halbleitertechnologie verträglich sind. Eine weitere Aufgabe der Erfindung besteht darin, ein neues elektrisch anregbares Lumineszenzmaterial, Verfahren zu seiner Herstellung und neue Anwendungen hierfür anzugeben.

Diese Aufgabe wird erfindungsgemäß durch eine Einrichtung gelöst, welche als lumineszentes Material oder als Sensormaterial Siloxen und/oder ein Siloxen-Derivat, insbesondere in polymerer, monokristalliner oder polykristalliner Form, enthält.

Siloxen ist ausgezeichnet mit Silizium verträglich, es läßt sich ohne giftige Stoffe, wie Arsen, Phosphor u. dgl. und in Form einer kompakten Schicht herstellen und seine Lumineszenzfarbe läßt sich leicht beeinflussen. Siloxen und Siloxen-Derivate lassen sich mit besonderem Vorteil in elektrooptischen Einrichtungen verwenden, wie Displays, elektrooptischen Schaltungen und IC's; wegen ihrer Struktureigenschaften und den verfügbaren Herstellungsverfahren ist ihre Verwendung jedoch auch in optischen Einrichtungen von Vorteil, in denen eine optische Anregung der Fluoreszenz stattfindet, z.B. zur Wellenlängenkonversion in einer Röntgen- oder UV-Bildwandlerschicht, in der integrierten Optik, z.B. als nichtlineares Material, in photoelektrischen Einrichtungen zur Energiekonversion, z.B. Solarzellen, als Lasermaterial usw.

Im folgenden wird die Erfindung anhand von Ausführungsbeispielen unter Bezugnahme auf die Zeichnungen näher erläutert. Es zeigen:
- Fig. 1 bis 3: drei verschiedene Strukturmodifikationen von Siloxen mit gleicher chemischer Zusammensetzung;
- Fig. 4: eine schematische Schnittansicht einer Halbleitereinrichtung gemäß der Erfindung, die Siloxen als elektrolumineszentes Material enthält,
- Fig. 5: eine Abwandlung der Einrichtung gemäß Fig. 4,
- Fig. 6: eine schematische Schnittansicht eines weiteren Ausführungsbeispiels der Erfindung,
- Fig. 7: eine schematische Ansicht einer Sensorvorrichtung gemäß der Erfindung, und
- Fig. 8: eine schematische Schnittansicht einer besonders einfachen Ausführungsform der Erfindung.

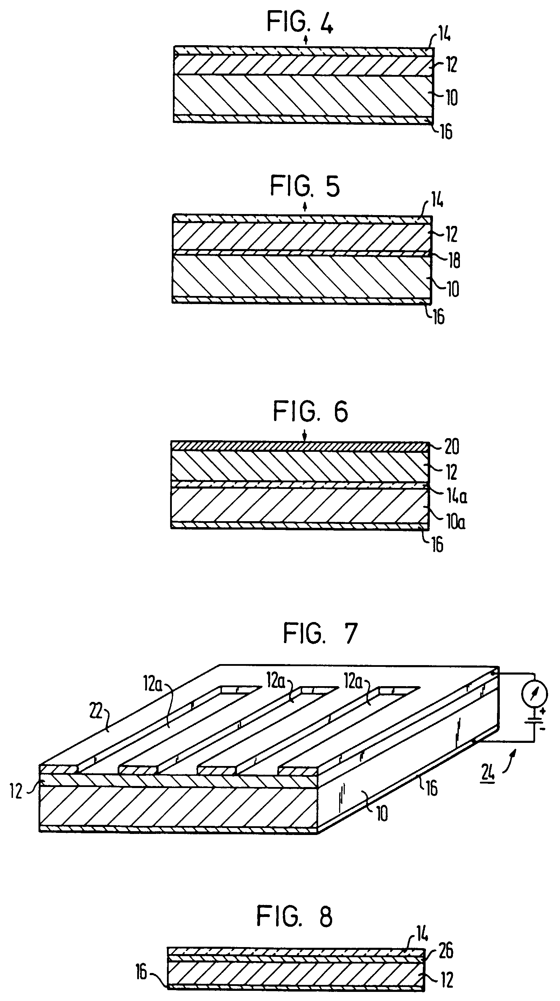

In den Fig. 4 bis 8 sind die Schichtdicken stark vergrößert und nicht maßstabsgerecht dargestellt.

Wenn hier und im folgenden gelegentlich nur auf Siloxen Bezug genommen wird, so gilt entsprechendes im allgemeinen auch für Siloxen-Derivate.

Siloxen Si₆O₃H₆ bzw. Si₆O₃₊ₙH₆₋ₘ und seine Derivate sind bekannt, siehe z.B. Gmelin, Silicium, Band B, S. 591-596. Es bildet eine hochpolymere, feste, unlösliche Substanz, die als wesentlichen Bestandteil Silizium-Sechserringe oder Silizium-Ebenen enthält.

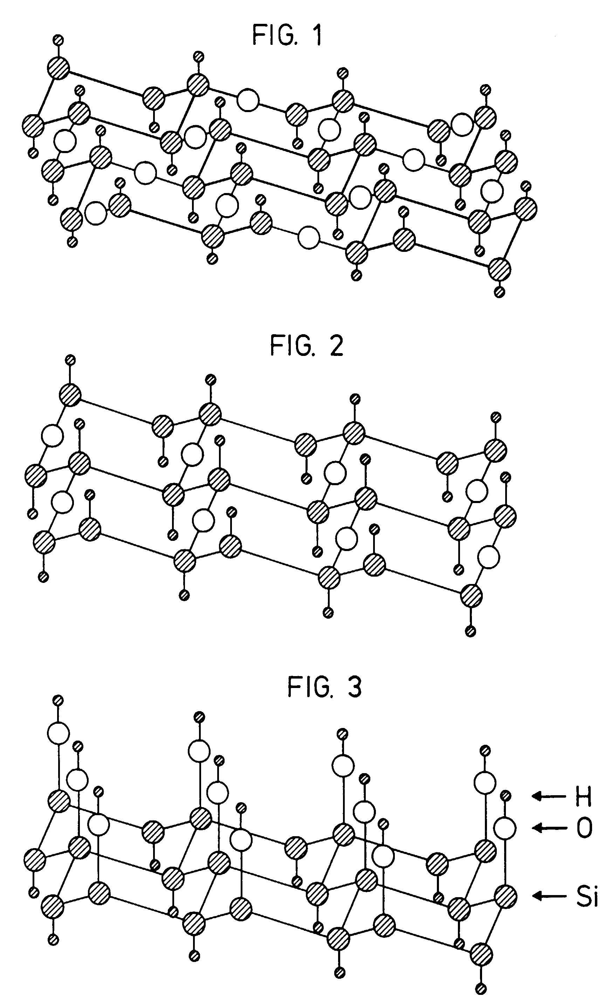

Drei verschiedene Strukturmodifikationen von Siloxen sind in den Fig. 1 bis 3 dargestellt, die jeweils einen Teil der [111]-Ebene eines Siloxenkristalles zeigen. Die großen ausgefüllten Kreise bedeuten Si-Atome, die großen leeren Kreise O-Atome und die kleinen ausgefüllten Kreise H-Atome. Die stabilste Struktur ist die gemäß Fig. 1, die ausgeprägte Sechs ringe enthält, welche durch Sauerstoffatome miteinander verknüpft sind.

Es ist auch bekannt, daß Siloxen Photolumineszenz und Chemolumineszenz zeigt und daß die Lumineszenzfarbe durch Substitution der H-Atome des Siloxens veränderbar ist. Nicht erkannt war jedoch bisher die Tatsache, daß Siloxen, insbesondere bei geeigneter Kontaktierung, auch Elektrolumineszenz zeigen kann und es war auch nicht erkannt worden, daß sich Siloxen aufgrund seiner Konstitution und der verfügbaren Herstellungsverfahren ausgezeichnet für Anwendungen in optischen einschließlich elektrooptischen Einrichtungen, insbesondere in Verbindung mit Silizium und Silizium-Halbleitereinrichtungen eignet.

Von besonderem Vorteil ist, daß die Gitterkonstanten von Siloxen mit der des Siliziums praktisch übereinstimmen. Man kann daher eine Siloxen-Schicht epitaktisch auf einen Silizium-Einkristall aufbringen, insbesondere auf eine [111]-Oberfläche des Siliziums. Es ist ferner möglich eine Oberflächenschicht eines monokristallinen oder polykristallinen Siliziumkörpers ohne wesentliche Änderung der Struktur dieser Schicht chemisch in Siloxen umzuwandeln. Ähnliches gilt für Saphirsubstrate und sog. SOS-Strukturen ("Silicon-on-Sapphire").

Ein weiterer wichtiger Vorteil ist, daß Siloxen-Schichten auch bei relativ niedrigen Temperaturen, insbesondere ≤800°C auch auf Halbleitersubstrate, insbesondere Silizium-Substrate, aufgebracht werden können, die eine integrierte Schaltung enthalten, so daß durch Anwendung von üblichen Halbleiterfertigungstechniken, wie Photomaskierung, eine gewünschte Konfiguration von elektrolumineszenten Einrichtungen auf der integrierten Schaltung hergestellt werden kann. Man erhält dadurch eine integrierte elektronisch-elektrooptische Schaltung. Siloxen und seine Derivate lassen sich auch mit Vorteil auf anderen Substraten verwenden, wie Glas, Quarz, Saphir, polymere Kunststoffe, wie PMMA.

Siloxen für die Verwendung als lumineszentes Material kann auf verschiedene Weise hergestellt werden, z.B. durch ein bekanntes naßchemisches Verfahren nach Kautsky (siehe z.B. Z. anorg. Chemie 117, 209-242 (1921) oder Wöhler (siehe z. B Liebigs Annalen **127**, 257, 1863), ferner durch Niederschlagen aus der Gasphase auf einem geeigneten Substrat, insbesondere, wie oben erwähnt, monokristallinem Silizium, z.B. unter Verwendung einer Mischung aus SiH₄, H₂O und/oder H₂, O₂ sowie einem Verdünnungsgas wie Argon oder einem anderen Edelgas oder Stickstoff, wobei die Reaktion durch Licht, insbesondere Laserstrahlung, durch eine Plasmaentladung, durch eine Hochfrequenz- oder Mikrowellenentladung, durch Zyklotronresonanz, durch Wärme, z.B. Erhitzen des Substrats, aktiviert werden kann. Weitere Möglichkeiten sind Abscheiden aus der flüssigen Phase, z.B. Flüssigkeitsphasenepitaxie, Spin-coating mittels einer Suspension, ferner Molekularstrahlabscheidung, z.B. Molekularstrahlepitaxie, wobei Silizium aus einer Effusionszelle verdampft wird und Wasserstoff sowie Sauerstoff als Ionenstrahlen zur Einwirkung gebracht werden. Auch elektrochemische Verfahren zur Herstellung von Siloxen sind bekannt.

Ein bekanntes naßchemisches Verfahren zur Herstellung von Siloxen besteht darin, Kalzium-Disilizid CaSi₂ (oder ein anderes geeignetes Metallsilicid ähnlicher Struktur, z.B. Silizide anderer Erdalkalielemente, wie Magnesium, Strontium und Barium) einige Stunden der Einwirkung rauchender Chlorwasserstoffsäure (38% HCl) auszusetzen und das Reaktionsprodukt zur Entfernung des Chlors mit Äther oder Wasser zu waschen. Bei einem anderen Verfahren dieser Art wird das Metallsilizid einige Stunden mit einer eisgekühlten Mischung aus Alkohol, Wasser oder HCl behandelt und anschließend mit Äther gewaschen. Hier hat sich insbesondere eine Mischung aus 60 Vol.-Teilen Äthanol, 11 Vol.-Teilen H₂O und 2 Vol.-Teilen conc. HCl bewährt.

Die Reaktion sowie das anschließende Waschen sollen unter Ausschluß von Sauerstoff im Dunkeln durchgeführt werden.

Zur Herstellung einer homogenen epitaktischen Siloxen-Schicht auf einem monokristallinen Siliziumsubstrat kann man Metallsilizid, insbesondere CaSi₂, in vorteilhafter Weise epitaktisch auf einer [111]-Fläche eines Siliziumkörpers erzeugen, wie es aus Veröffentlichungen von J.F. Morar et al in Physical Review B, Band 37, Nr. 5, 15. Februar 1988, S. 2618-2621 und J. Vac. Sci. Technol. A 6(3), Mai/Juni 1988, S. 1340-1342 bekannt ist. Bei diesem Verfahren wird auf einer Fläche eines Siliziumsubstrats, am besten auf einer polierten [111]-Fläche eines Si-Einkristalles, eine Schicht aus Kalziummetall mit gewünschter Dicke, z. B. 100 bis 500nm aufgedampft und durch Erhitzen auf etwa 800°C einlegiert. Diese Schicht wird dann in der oben beschriebenen Weise durch Einwirkung von HCl naßchemisch in Siloxen umgewandelt. Man erhält kann auf diese Weise eine dichte, homogene epitaktische Siloxenschicht auf einem monokristallinen Si-Substrat herstellen, welche durch Photoätzung, Korpuskularstrahlätzung oder irgendein anderes bekanntes Halbleiterstrukturierungsverfahren strukturiert werden kann.

Es besteht ferner die Möglichkeit, in einem geeigneten Lösungsmittel (z.B. Äthanol) suspendiertes Siloxen als gleichmäßige dünne Schicht auf ein Substrat aufzubringen z.B. durch Schleuderbeschichtung (Spin-Coating).

Bei einer elektrolumineszenten elektronischen Einrichtung weist das Substrat der gegebenenfalls strukturierten Siloxenschicht ein entsprechendes Elektrodenmuster auf und auf die freie Oberfläche des Siloxens wird eine entsprechende, transparente Gegenelektrodenanordnung, z.B. aus einer dünnen, transparenten Schicht aus Gold oder Zinnoxid, aufgebracht.

Eine besonderes vorteilhafte Konfiguration einer elektrooptischen Einrichtung besteht aus einer Schichtstruktur, die der Reihe nach ein Substrat aus p- oder n-leitend dotiertem monokristallinem Silizium, eine dünne, transparente dielektrische Schicht z.B. aus SiO₂ oder Si₃N₄, eine Schicht aus Siloxen oder Siloxen-Derivat und eine transparente Gegenelektrode, z.B. aus Gold, Zinn- oder Indiumoxid enthält. Die transparente dielektrische Zwischenschicht hat die wichtige Funktion, die Erzeugung hoch angeregter Ladungsträger durch ein hohes elektrisches Feld (Injektion durch Tunneln) zu erzeugen. Die beschriebene Struktur kann gegen schädliche Umwelteinflüsse durch eine dünne transparente Schicht geschützt werden.

Das Siloxen soll auch in anderen Fällen durch eine Schutzschicht, z.B. aus einem transparenten Material, wie SiO₂, geschützt werden, die das Siloxen gegen die Einwirkung von Sauerstoff, Feuchtigkeit und anderen schädlichen Umweltseinflüssen schützt, die optische Funktion jedoch nicht beeinträchtigt.

Ein besonderer Vorteil der Verwendung von Siloxen als lumineszentes Material besteht darin, daß die Lumineszenzfarbe durch Erhitzen und/oder Substitution, auch in situ und ortsselektiv, geändert werden kann. Dies ist im Falle der Photolumineszenz von Siloxen bekannt und man kann sich für die Einstellung der Lumineszenzfarbe der bekannten Substitutionsverfahren und Substituenten bedienen.

Die Wasserstoffatome des Siloxens können sukzessive substituiert werden, z.B. durch Halogene, insbesondere Cl, durch OH-Gruppen, durch einen Alkohol, wobei z. B. an die Stelle des Wasserstoffs des Siloxens eine Bindung eines C-Atoms des Alkohols treten kann, oder durch andere einwertige Radikale mit einer anderen Elektronegativität als Wasserstoff. Durch die Substituierung tritt eine Aufweitung des Kristallgitters des Siloxens in der [111]-Richtung auf. Weiterhin erfolgt eine Verschiebung der Fluoreszenz nach längeren Wellenlängen. Bei der Substituierung kann man sich bekannter Verfahren bedienen, siehe z.B. E. Hengge, Fortschritte der chemischen Forschung, **9**, 145 (1967) und H. Ubara et. al., J. Non-Cryst. Solids **59&60**, 641 (1983).

Da die Substituierung nach der Bildung und Struktuierung einer Siloxen-Schicht erfolgen kann, läßt sich die Substituierung örtlich unterschiedlich durchführen, z.B. indem man Teile der Siloxenschicht, bei denen keine oder eine andere Substituierung erfolgen soll, während der Substituierung z.B. photolithographisch abdeckt. Man kann auf diese Weise auf einer integrierten Schaltung oder einer anderen elektrooptischen Einrichtung Siloxen-Bereiche vorsehen, die bei elektrischer oder optischer Anregung mit unterschiedlichen Farben emittieren.

Die elektrischen Eigenschaften des Siloxens bzw. der Siloxenderivate können durch Erhitzen und/oder Dotierung gezielt verändert werden.Die elektrische Leitfähigkeit des Siloxens kann durch Substitution eines Siliciumatoms der Ebene oder durch interstitielle Dotierung insbesondere mit Alkalimetallen, wie Li, Cs beeinflußt werden. Des weiteren kann die Leitfähigkeit der Ebene durch Interkalation von geeigneten Molekülen zwischen je zwei Ebenen geändert werden. Da undotiertes Siloxen ein Isolator ist, kann schließlich auch durch Ladungstransfer aus einem leitenden Substrat in die Siliziumebenen hinein die Leitfähigkeit der letzteren in einer Feldeffektkonfiguration variiert werden.

Eine Eigenschaft der Lumineszenz von Siloxen und dessen Derivaten ist eine breite Verteilung von Anregungslebensdauern, die für Anwendungen in der optoelektronischen Nachrichtentechnik (Datenübertragung) unerwünscht sein kann. Hier kann es notwendig werden, die Anregungslebensdauern gezielt durch Einbau von Rekombinationszentren, insbesondere in Form von Kristalldefekten, zu steuern. Dies kann z.B. durch Behandlung mit ionisierender Strahlung, wie Ionenstrahlen, oder durch Oxidation erfolgen und man kann den Einbau von Rekombinationszentren ortsselektiv durchführen, um eine örtliche Strukturierung der Emissionseigenschaften einer Siloxen-Schicht zu erhalten.

Die Verwendung von Siloxen und Siloxenderivaten ist wegen deren Struktureigenschaften sowie den optischen Eigenschaften, insbesondere der effizienten Photolumineszenz auch in anderen, nicht mit elektrischer Anregung des Siloxens arbeitenden optischen Einrichtungen, die mit Lumineszenz arbeiten, von Vorteil. Mit den oben angegebenen Herstellungsverfahren ist es möglich, epitaktische Schichten oder dünne Filme mit räumlich konstantem oder gesteuert veränderlichem Brechungsindex aus Siloxen auf Substraten, wie kristallinem Silizium abzuscheiden. Beispiele solcher Anwendungen sind die Verwendung von dünnen Siloxenschichten auf Silizium als Sensorelemente oder optische Wellenleiter. Ein konkretes Beispiel ist ein Sensor für oxidierende Medien. Die Oxidation des Siloxens erzeugt eine Chemolumineszenz, die im Silizium elektrisch detektiert wird.

Vorteilhaft ist ferner die Deposition von Siloxen oder Siloxenderivat auf bestehende photoempfindliche Strukturen zur spektralen Anpassung (Solarzellen, Bildwandler, insbesondere zur Konvertierung von Korpuskularstrahlung, Röntgenstrahlung oder ultraviolettem Licht in sichtbare Strahlung zur Verbesserung der Empfindlichkeit). Hiermit kann insbesondere der starke Abfall der Quanteneffizienz von Photodioden auf der Basis von kristallinem Silizium im Wellenlängenbereich oberhalb 400 nm zumindest teilweise kompensiert werden. Eine Erhöhung des Wirkungsgrades von Si-Solarzellen wird durch eine dünne Schicht aus Siloxen ermöglicht, sie wirkt als Antireflexschicht und setzt kurzwelliges Licht, insbesondere UV, in Licht längerer Wellenlängen um, für das die Si-Solarzelle eine höhere Empfindlichkeit hat.

Da Siloxen keine Inversionssymmetrie hat (die Kristallstruktur kann durch Spiegelung an einem Punkt nicht in sich selbst übergeführt werden) kann es zur optischen Frequenzverdopplung verwendet werden.

Siloxenschichten genügender Dicke eignen sich als Szintillatormaterial zum Nachweis ionisierender Strahlung und können mit einer Materialkombination (Siloxen auf Silizium) verwendet werden, die vollkommen kompatibel mit der Siliziumtechnologie ist. Der Vorteil liegt hier insbesondere in der Tatsache, daß keine Verunreinigungen eingebracht werden und daß bei der Abscheidung von Siloxen, z.B. aus einem Plasma, auch große Flächen hergestellt werden können.

Diese Anwendung ist z.B. in Kombination mit großflächigen amorphen Siliziumsubstraten sinnvoll.

Ein weiterer Anwendungsbereich ist die integrierte Optik auf der Basis von Silizium. Hier werden derzeit Materialien wie SiO₂ oder Oxinitride in Betracht gezogen, die aber im sichtbaren Bereich optisch nicht aktiv sind. Siloxen ist ähnlich wie die obengenannten Dielektrika mit der Siliziumtechnologie kompatibel, hat einen kleineren Brechungsindex als Silizium und weist außerdem wegen seiner großen Lumineszenzausbeute Eigenschaften auf, die bei der Erzeugung von optisch aktiven Bauelementen in der integrierten Optik ausgenutzt werden können, ohne daß hierfür Stoffe benötigt werden, die der Siliziumtechnologie fremd sind. Das Siloxen oder Siloxenderivat kann bei dieser Anwendung beispielsweise als optisch nichtlineares Material für optische Modulatoren, für Multiplexer und Laser verwendet werden. Siloxen in kristalliner Form oder in einer Suspension kann auch direkt als aktives Lasermaterial Verwendung finden.

Die Elektrolumineszenz kann sowohl mit Gleichstrom als auch mit Wechselstrom angeregt werden.

Im folgenden sollen nun unter Bezugnahme auf die Fig. 4 bis 8 einige spezielle Ausführungsbeispiele der Erfindung erläutert werden.

Fig. 4 zeigt eine elektrolumineszente Einrichtung, die ein Substrat 10 aus dotiertem monokristallinem Silizium enthält. Das Substrat ist bei diesem Beispiel stark n-leitend und hat einen spezifischen Widerstand in der Größenordnung von einigen Ohm-cm. Auf dem das Substrat 10 bildenden Siliziumeinkristall befindet sich eine epitaktische Siloxenschicht 12 und auf dieser wiederum eine transparente Elektrode 14 aus SnO₂ oder einem anderen bekannten transparenten leitenden und mit Siloxen verträglichen Material. An der der Siloxenschicht 12 abgewandten Seite des Substrats 10 ist eine Rückelektrode 16 in Form einer aufgedampften Aluminiumschicht oder dgl. angebracht.

Wenn an die Elektroden 14, 16 eine Spannung angelegt wird, werden Elektronen vom n-leitenden Substrat 10 und Löcher aus der transparenten Gegenelektrode 14 in die Siloxenschicht 12 injiziert, so daß in dieser eine Elektrolumineszenz auftritt.

Anstelle eines n-leitenden Substrats kann auch ein p-leitendes Substrat verwendet worden, wobei sich dann die erwähnten Vorzeichen der Ladungsträger umkehren.

Die Ausführungsform gemäß Fig. 5 stimmt mit der gemäß Fig. 4 überein, mit der Ausnahme, daß zwischen dem Substrat 10 und der Siloxenschicht 14 eine dünne Isolierschicht 18 angeordnet ist. Bei einem praktischen Ausführungsbeispiel besteht die Isolierschicht 18 aus SiO₂ und hat eine Dicke von etwa 5 nm bis 100 nm. Hierfür kann gegebenenfalls ein handelsübliches Si-Substratmaterial mit vergrabener Oxidschicht verwendet werden. Die Isolierschicht 18 ist so dünn, daß sie von den Ladungsträgern, also hier Elektronen, durchtunnelt wird, wenn an die Elektrode 16 eine bezüglich der Elektrode 14 negative Spannung ausreichender Größe angelegt wird. Bei dieser Anordnung haben die in die Siloxenschicht 14 injizierten Ladungsträger eine höhere Energie bezüglich der Leitungsbandkante von Siloxen als bei der Einrichtung gemäß Fig. 4, so daß sich auch eine effizientere Injektion und damit eine höhere Lumineszenzausbeute ergeben.

Die Einrichtung gemäß Fig. 6 enthält als Substrat 10a eine pn- oder pin-Photodiode üblicher Bauart, die eine Rückelektrode 16 und auf ihrer Lichteintrittsseite eine transparente Elektrode 14a aufweist. Auf der transparenten Elektrode 14a befindet sich eine Siloxenschicht 12, die ihrerseits durch eine transparente Schutzschicht 20, z.B. aus Siliciumdioxid, abgedeckt ist. Elektromagnetische Strahlung, insbesondere kurzwellige Strahlung wie UV oder Röntgenstrahlung, sowie Korpuskularstrahlung, die durch die Schutzschicht 20 in die Siloxenschicht 12 eintritt, wird dort in Strahlung längerer Wellenlänge umgesetzt, die ihrerseits wiederum von der Photodiode 10a, 14a, 16 mit hohem Wirkungsgrad in ein elektrisches Signal umgesetzt wird.

Bei einer Abwandlung der Einrichtung gemäß Fig. 6, die als Sensoreinrichtung verwendet werden kann, fehlt die Schutzschicht 20, oder sie ist durchlässig oder mit Löchern versehen, so daß eine nachzuweisende Substanz in der Siloxenschicht Chemolumineszenz erzeugen kann, die durch die Photodiode 10a detektiert wird.

Fig. 7 zeigt eine Sensoreinrichtung, die ein Substrat 10 aus dotiertem Silizium, einer an dessen Rückseite angebrachte Rückelektrode 16 und eine auf der Oberseite angeordnete Siloxenschicht 12 enthält. Auf der Siloxenschicht befindet sich eine Elektrodenstruktur 22, die hier kammartig ausgebildet ist und Teile 12a der Oberfläche der Siloxenschicht freiläßt, so daß diese Teile der Atmosphäre ausgesetzt sind. Bei Einwirkung von Radikalen, wie oxidierenden Radikalen, Halogenen usw. ändert sich die Leitfähigkeit der diodenähnlichen Struktur, die durch das Siliziumsubstrat 10 und die Siloxenschicht 12 gebildet wird. In einem diese Struktur enthaltenden, nur schematisch dargestellten Stromkreis 24 tritt dann ein entsprechendes Signal auf.

Fig. 8 zeigt ein besonders einfaches Ausführungsbeispiel. Die Einrichtung gemäß Fig. 8 enthält eine dünne Siloxenschicht 12 die auf der einen Seite mit einer Rückelektrode 16 und auf der anderen Seite mit einer transparenten Elektrode 14 versehen ist. Durch Anlegen einer Wechselspannung an die Elektroden 14, 16 wird das Siloxen zur Elektrolumineszenz angeregt. Die Rückelektrode kann als Trägerstruktur ausgebildet sein und dann z.B. aus einer Metallplatte bestehen und/oder sie kann einen injizierenden Kontakt, z.B. einen Schottky-Kontakt bilden. Zwischen der Siloxenschicht 12 und der transparenten Elektrode 14 ist hier noch eine dünne transparente dielektrische Schicht 26, aus SiO₂ o. dgl. angeordnet, die die Erzeugung einer höheren Feldstärke in Siloxen gestattet. Eine solche dielektrische Schicht kann auch bei den Einrichtungen gemäß Fig. 4, 5 und 7 vorgesehen sein.

Siloxen kann auch mit Vorteil als Leuchtstoff in Leuchtstoffröhren verwendet werden, insbesondere in Kombination mit anderen Leuchtstoffen. Das Siloxen wird hier sowohl durch die in der Entladung erzeugte UV-Strahlung als auch durch Elektronenstoß angeregt.

## Patentansprüche

1. Optoelektronische Vorrichtung mit einem lumineszenzfähigen Material (12), **gekennzeichnet durch** Siloxen und/oder Siloxenderivat als lumineszenzfähiges Material und durch zwei Elektroden (14, 16) zur Lumineszenzanregung, von denen mindestens eine für die emittierte Strahlung transparent ist und zwischen denen das Siloxen oder Siloxenderivat angeordnet ist.

2. Vorrichtung nach Anspruch 1, **dadurch gekennzeichnet,** daß eine dielektrische Schicht (26) zwischen dem Siloxen oder Siloxenderivat und einer Elektrode angeordnet ist.

3. Vorrichtung nach Anspruch 1 oder 2, **dadurch gekennzeichnet,** daß das Siloxen oder Siloxenderivat als eine Schicht (12) auf einem dotierten Silizium-Substrat (10) angeordnet ist und die erste transparente Elektrode (14) auf der dem Substrat abgewandten Oberfläche der Schicht angeordnet ist und die zweite Elektrode (16) auf der der Schicht abgewandten Oberfläche des Substrats angeordnet ist.

4. Vorrichtung nach Anspruch 3, **dadurch gekennzeichnet,** daß eine dielektrische Schicht (18) zwischen der Schicht (12) und dem Substrat (10) angeordnet ist.

5. Vorrichtung nach Anspruch 4, **dadurch gekennzeichnet,** daß die Schicht (18) SiO₂ enthält.

6. Vorrichtung nach einem der Ansprüche 3 bis 5, **dadurch gekennzeichnet,** daß das Silizium-Substrat eine integrierte Schaltung enthält.

7. Vorrichtung nach einem der Ansprüche 3 bis 6, **dadurch gekennzeichnet,** daß die Schicht (12) eine epitaktische Schicht ist.

8. Verfahren zum Herstellen einer Vorrichtung gemäß einem oder mehreren der Ansprüche 1 bis 7, wobei auf dem Silizium-Substrat eine Calcium-Schicht niedergeschlagen wird, das Calcium durch Erhitzen in das Silicium oberflächlich einlegiert wird und die Legierungsschicht anschließend in Siloxen umgewandelt wird.

9. Verfahren nach Anspruch 8, **dadurch gekennzeichnet,** daß die Umwandlung durch Behandeln mit einer HCl enthaltenden Flüssigkeit und anschließendes Waschen erfolgt.

10. Verfahren nach Anspruch 8 oder 9, **dadurch gekennzeichnet,** daß mindestens ein Teil des Wasserstoffs des Siloxens substituiert wird.

11. Verfahren nach Anspruch 10, **dadurch gekennzeichnet,** daß die Substitution ortsselektiv durchgeführt wird.

12. Verfahren nach einem oder mehreren der Ansprüche 8 bis 11, **dadurch gekennzeichnet,** daß Rekombinationszentren und/oder Dotieratome, vorzugsweise ortsselektiv, in das Siloxen bzw. Siloxenderivat eingebaut werden.

13. Verwendung einer Vorrichtung gemäß einem oder mehreren der Ansprüche 1 bis 7 in einem Display.

14. Verwendung einer Vorrichtung gemäß einem oder mehreren der Ansprüche 1 bis 7 in einer Energie- oder Bildwandlereinrichtung.

15. Verwendung einer Vorrichtung gemäß einer oder mehreren der Ansprüche 1 bis 7 in einer optoelektronischen oder einer integrierten optischen Einrichtung.

16. Verwendung einer Vorrichtung gemäß einem oder mehreren der Ansprüche 1 bis 7 in einer Szintillatoranordnung.

## Claims

1. Opto-electronical device with a luminescent material (12) characterized by siloxene and/or a siloxene derivative as the luminescent material and by two electrodes (14, 16) for luminescence stimulation at least one of which being transparent for the emitted radiation wherein the siloxene or siloxene derivative is positioned between the electrodes.

2. Device according to claim 1, characterized in that, a dielectric layer (26) is positioned between the siloxene or siloxene derivative and an electrode.

3. Device according to claim 1 or 2, characterized in that the siloxene or siloxene derivative is positioned as a layer (12) on a doped silicone substrate and the first transparent electrode (14) is positioned on the layer on a surface facing away from the substrate and the second electrode (16) is positioned on a surface of the substrate facing away from the layer.

4. Device according to claim 3, characterized in that a dielectric layer (18) is positioned between the layer (12) and the substrate (10).

5. Device according to claim 4, characterized in that the layer (18) contains SiO₂.

6. Device according to one of the claim 3 to 5, characterized in tha the silicon substrate contains an integrated circuit.

7. Device according to one of the claims 3 to 6, characterized in that the layer (12) is an epitactical layer.

8. Method for producing a device according to one or several of the claims 1 to 7 wherein a calcium layer is deposited on the silicon substrate, the calcium is superficially alloyed into the silicon by heating and the alloy layer subsequently is inverted into siloxene.

9. Method according to claim 8 characterized in that the conversion is effected by a treatment with an HCl-containing liquid and subsequent washing.

10. Method according to claim 8 or 9, characterized in that at least a portion of hydrogene of the siloxene is substituted.

11. Method according to claim 10, characterized in that the substitution is carried out in locally selective manner.

12. Method according tc one or several of the claims 8 to 11, characterized in that the recombination centers and/or doping atoms are incorporated preferably in a locally selective manner into the siloxene or siloxene derivative.

13. Use of a device according to one or several of the claims 1 to 7 in a display.

14. Use of a device according to one or several of the claims 1 to 7 in an energy converter or image converter.

15. Use of a device according to one or several of the claims 1 to 7 in an opto-electronical or in an integrated optical means.

16. Use of a device according to one or several of the claims 1 to 7 in a scintillator device.

## Revendications

1. Dispositif optoélectronique, comportant un matériau luminescent (12), caractérisé en ce qu'il comprend, en tant que matériau luminescent, du siloxène et/ou un dérivé du siloxène et deux électrodes (14,16) pour l'excitation de la luminescence dont l'une au moins est transparente pour le rayonnement émis et entre lesquelles est disposé le siloxène ou le dérivé du siloxène.

2. Dispositif suivant la revendication 1 caractérisé en ce qu'une couche diélectrique (26) est disposée entre le siloxène ou le dérivé du siloxène et une électrode.

3. Dispositif suivant l'une quelconque des revendications 1 ou 2 caractérisé en ce que le siloxène ou le dérivé du siloxène est disposé, sous la forme d'une couche (12), sur un substrat (10) en silicium dopé, la première électrode transparente (14) est disposée sur la surface de la couche qui se trouve à l'opposé du substrat et la seconde électrode (16) est disposée sur la surface du substrat qui se trouve à l'opposé de la couche.

4. Dispositif suivant la revendication 3 caracténsé en ce qu'une couche diélectrique (18) est disposée entre la couche (12) et le substrat (10).

5. Dispositif suivant la revendication 4 caractérisé en ce que la couche (18) contient SiO₂.

6. Dispositif suivant l'une quelconque des revendications 3 à 5 caractérisé en ce que le substrat en silicium contient un circuit intégré.

7. Dispositif suivant l'une quelconque des revendications 3 à 6 caractérisé en ce que la couche (12) est une couche épitaxiale.

8. Procédé de fabrication d'un dispositif suivant une ou plusieurs des revendications 1 à 7, caractérisé en ce qu'on dépose une couche de calcium sur le substrat en silicium, on allie le calcium, par chauffage, dans la surface du silicium et on transforme finalement la couche d'alliage en siloxène.

9. Procédé suivant la revendication 8 caractérisé en ce qu'on effectue la transformation au moyen d'un traitement avec un fluide contenant du HCl et d'un lavage final.

10. Procédé suivant l'une quelconque des revendications 8 ou 9 caractérisé en ce qu'au moins une partie de l'hydrogène du siloxène est substituée.

11. Procédé suivant la revendication 10 caractérisé en ce que la substitution est effectuée sélectivement en fonction de l'emplacement.

12. Procédé suivant l'une quelconque des revendications 8 à 11 caractérisé en ce que des centres de recombinaison et/ou des atomes de dopage sont incorporés dans le siloxène ou le dérivé du siloxène, de préférence avec une sélection de leurs emplacements.

13. Utilisation d'un dispositif suivant une ou plusieurs des revendications 1 à 7 dans un afficheur.

14. Utilisation d'un dispositif suivant une ou plusieurs des revendications 1 à 7 dans un dispositif convertisseur d'énergie ou d'image.

15. Utilisation d'un dispositif suivant une ou plusieurs des revendications 1 à 7 dans un dispositif optoélectronique ou dans un dispositif optique intégré.

16. Utilisation d'un dispositif suivant une ou plusieurs des revendications 1 à 7 dans un scintillateur.
